# EUROPÄISCHE PATENTANMELDUNG

(11) **EP 1 521 354 A2**
(43) Veröffentlichungstag der Anmeldung: **06.04.2005**
(21) Anmeldenummer: 04018806.2
(22) Anmeldetag: 07.08.2004
(51) Int. Cl.: H02M 7/217, H02M 3/335, H03K 17/06

(54) **Synchrongleichrichter**

(30) Priorität: 02.10.2003 DE 10345929
(71) Anmelder: ROBERT BOSCH GMBH, 70442 Stuttgart (DE)
(72) Erfinder: Etzold, Peter, 73061 Ebersbach (DE)

(57) **Zusammenfassung**

Die Erfindung betrifft einen elektronischen Diodenschaltkreis mit einer Anode (A) und einer Kathode (K). Er umfasst zumindest einen zwischen die Anode und die Kathode geschalteten Feld-Effekt-Transistor (T1,T2) mit einem Gate, einer Source und einer Drain, wobei die Kathode durch die Drain repräsentiert wird. Er umfasst weiterhin eine zwischen das Gate und die Source des FET geschaltete Impedanz zum sicheren Sperren des FET bei fehlender Ansteuerung des FET. Schießlich umfasst er einen Operationsverstäker (OP1), dessen nicht-invertierender Eingang (+) an die Anode, dessen invertierender Eingang (-) an die Kathode und dessen Ausgang an das Gate des FET angeschlossen sind zum Steuern des Betrags der Gatespannung nach Maßgabe durch die Potentialdifferrenz zwischen der Anode (A) und der Kathode (K). Der Diodenschaltkreis arbeitet als Synchrongleichrichter und gestattet vorteilhafter Weise ein Ein- und Ausschalten eines gleichgerichteten Stromes.

## Beschreibung

Die Erfindung betrifft einen elektronischen Diodenschaltkreis mit einer Anode und einer Kathode. Darüber hinaus betrifft die Beschreibung ein Ladegerät zum Aufladen eines Akkumulators in dem der elektronische Diodenschaltkreis Gemäß der Erfindung Anwendung findet.

### Stand der Technik

Dioden sind als elektronische Bauelemente zum Beispiel in Form von Schottky-Dioden grundsätzlich bekannt. Darüber hinaus sind auch Feld-Effekt-Transistoren FETs grundsätzlich bekannt. Herkömmliche Dioden haben jedoch den Nachteil, dass sie auch in Durchlassrichtung noch einen relativ hohen ohmschen Widerstand aufweisen und deshalb relativ hohe ohmsche Verluste aufweisen.

Ausgehend von diesem Stand der Technik ist es die Aufgabe der Erfindung, einen elektronischen Diodenschaltkreis und ein Ladegerät zum Aufladen von Akkumulatoren in dem dieser elektronische Diodenschaltkreis Anwendung findet, bereitzustellen, wobei der Diodenschaltkreis im Vergleich zu einer herkömmlichen Diode in Durchlassrichtung einen wesentlich geringeren Widerstand aufweist.

Diese Aufgabe wird durch den Gegenstand des Patentanspruchs 1 gelöst. Demnach ist der erfindungsgemäß elektronische Schaltkreis gekennzeichnet durch mindestens einen zwischen die Anode und die Kathode geschalteten Feld-Effekt-Transistor FET mit einem Gate, einer Source und einer Drain, wobei die Kathode durch die Drain repräsentiert wird, und einen Operationsverstärker, dessen nicht-invertierender Eingang an die Anode, dessen invertierender Eingang an die Kathode und dessen Ausgang, erforderlichenfalls über einen Widerstand, an das Gate des FET angeschlossen sind, zum Steuern des Betrages der Gatespannung nach Maßgabe durch die Potentialdifferenz zwischen der Anode und der Kathode.

### Vorteile der Erfindung

Das Besondere an dem beanspruchten elektronischen Diodenschaltkreis ist darin zu sehen, dass seine Gatespannung nicht etwa von einem externen Steuersignal, sondern quasi durch ein internes Steuersignal, welches den Betriebszustand des FET selber repräsentiert, gesteuert wird. Genauer gesagt, erfolgt die Steuerung nach Maßgabe durch die Potentialdifferenz zwischen der Anode und der Kathode des Schaltkreises, wobei diese Potentialdifferenz den Betriebszustand des FET repräsentiert. Der beanspruchte Diodenschaltkreis wirkt grundsätzlich als Diode, deren ohmscher Widerstand und damit deren Stromdurchlässigkeit durch die Polarität der Potentialdifferenz an den Eingängen des Operationsverstärkers bestimmt wird. Der ohmsche Widerstand und damit auch die Verlustleistung des erfindungsgemäßen Diodenschaltkreises sind jedoch im Vergleich zu einer herkömmlichen Diode vorteilhafterweise wesentlich geringer.

Bei einer positiven Potentialdifferenz leitet die Source-Drain-Verbindung innerhalb des FET und stellt damit einen sehr niederohmigen und damit verlustleistungsarmen Strompfad zur Verfügung. Die FET-interne Diode ist stromlos, da ihre Flussspannung nicht erreicht wird. Bei negativer Potentialdifferenz sperrt der Diodenschaltkreis vollständig.

Vorteilhafterweise ist eine Impedanz zwischen das Gate und die Source des FET geschaltet ist; diese unterstützt beim Ausschalten des FET die Entladung von dessen Gate-Source-Kapazität und bewirkt auf diese Weise ein sicheres Sperren des FET, insbesondere bei fehlender Versorgungsspannung für den Operationsverstärker.

Gemäß einem zweiten vorteilhaften Ausführungsbeispiel des erfindungsgemäßen elektronischen Diodenschaltkreises umfasst dieser weiterhin ein gesteuertes Schaltelement mit dessen Hilfe die Gatespannung des FET unabhängig von der tatsächlichen Polarität der Potentialdifferenz zwischen Anode und Kathode des Diodenschaltkreises jederzeit im Ansprechen auf ein Steuersignal zu Null gemacht werden kann. Diese Unabhängigkeit von der tatsächlichen Potentialdifferenz ist für manche Anwendungen von Vorteil. Das Schaltelement ermöglicht vorteilhafterweise ein Sperren des FET nicht nur unabhängig von der Polarität der Potentialdifferenz am Eingang des Operationsverstärkers, sondern auch vorrangig gegenüber dieser, weil es direkt an dem Gate des FET angeschlossen ist.

Während die elektronischen Diodenschaltkreise gemäß dem ersten und zweiten Ausführungsbeispiel mit lediglich einem FET aufgrund der in dem FET vorhandenen internen Diode einen Stromfluss auch bei einer Gatespannung von Null Volt niemals gänzlich unterbinden können, ist es vorteilhaft, wenn der Diodenschaltkreis gemäß einem dritten Ausführungsbeispiel zusätzlich einen zweiten FET aufweist, der mit seiner Source an die Source des ersten FET angeschlossen ist und mit seiner Drain an die Anode des Diodenschaltkreises angeschlossen ist. Der zweite FET ist also entgegengesetzt zu dem ersten FET geschaltet. Mit Hilfe des zweiten FETs lässt der Diodenschaltkreises in einen dritten Zustand hinsichtlich seiner Stromdurchlässigkeit steuern, welcher sich dadurch auszeichnet, dass der Diodenschaltkreis auch bei positiver Potentialdifferenz sehr hochohmig und damit de facto stromundurchlässig ist. Der Diodenschaltkreis verhält sich damit wie ein geöffneter Schalter.

Es ist weiterhin von Vorteil, dass der erfindungsgemäße elektronische Diodenschaltkreis in all seinen Ausführungsbeispielen auf einem Halbleiterchip integriert werden kann.

Ein bevorzugtes Anwendungsgebiet für den erfindungsgemäßen elektronischen Schaltkreis sind Ladegeräte zum Aufladen eines Akkumulators. Der erfindungsgemäße Diodenschaltkreis wird besonders vorteilhaft in Gleichrichtereinrichtungen solcher Ladegeräte verwendet, wo er klassische Dioden vorteilhaft ersetzen kann, weil er in Stromdurchlassrichtung in einen wesentlich niederohmigeren und damit verlustärmeren Zustand geschaltet werden kann, als reine Dioden.

Die obige Aufgabe der Erfindung wird weiterhin durch eine Gleichrichtereinrichtung und ein Ladegerät zum Aufladen eines Akkumulators gelöst. Dabei sind die Diodenschaltkreise in der Gleichrichtereinrichtung und dem des Ladegerätes erfindungsgemäß aus jeweils mindestens einem FET gebildet. Insbesondere können die Diodenschaltkreise auch gemäß dem oben beschriebenen erfindungsgemäßen Diodenschaltkreis ausgebildet sein. Die Vorteile eines solchen Ladegerätes entsprechen im Wesentlichen den oben mit Bezug auf den elektronischen Diodenschaltkreis genannten Vorteile.

### Figuren:

Der Beschreibung sind insgesamt 8 Figuren beigefügt, wobei
- Figur 1: ein erstes Ausführungsbeispiel des erfindungsgemäßen elektronischen Diodenschaltkreises;
- Figur 2: ein zweites Ausführungsbeispiel des erfindungsgemäßen elektronischen Diodenschaltkreises;
- Figur 3: ein drittes Ausführungsbeispiel des erfindungsgemäßen elektronischen Diodenschaltkreises;
- Figur 4: ein erstes Ausführungsbeispiel für ein Ladegerät zum Aufladen eines Akkumulators;
- Figur 5: ein zweites Ausführungsbeispiel für ein Ladegerät zum Aufladen eines Akkumulators;
- Figur 6a: die Verläufe einer ersten und einer zweiten Sekundärspannung auf der Sekundärseite eines Transformators mit Mittelanzapfung des Ladegeräts gemäß Figur 5;
- Figur 6b: den Verlauf der Gatespannung U_{G1} gemäß Figur 5;
- Figur 6c: den Verlauf der Gatespannung U_{G2} gemäß Figur 5;
- Figur 6d: die Verläufe der Ladeströme in der beiden Zweigen der Gleichrichtereinrichtung des Ladegeräts Gemäß Figur 5;
- Figur 7: ein Beispiel für eine Ansteuerung der Diodenschaltkreise in dem Ladegerät gemäß Figur 5;
- Figur 8a: den Verlauf der Ausgangsspannung des ersten Operationsverstärkers OP1 gemäß Figur 7;
- Figur 8b: den Verlauf der Ausgangsspannung des zweiten Operationsverstärkers OP2 gemäß Figur 7;
- Figur 8c: den Verlauf eines Steuersignals S zur Ansteuerung der beiden Transistoren in Figur 7 und
- Figur 8d: den Verlauf des Ladestroms durch einen Akkumulator, wenn dieser durch das erfindungsgemäße Ladegerät aufgeladen wird;
zeigt.

### Beschreibung der Ausführungsbeispiele

Die Erfindung wird nachfolgend detailliert in Form verschiedener Ausführungsbeispiele unter Bezugnahme auf die genannten Figuren beschrieben.

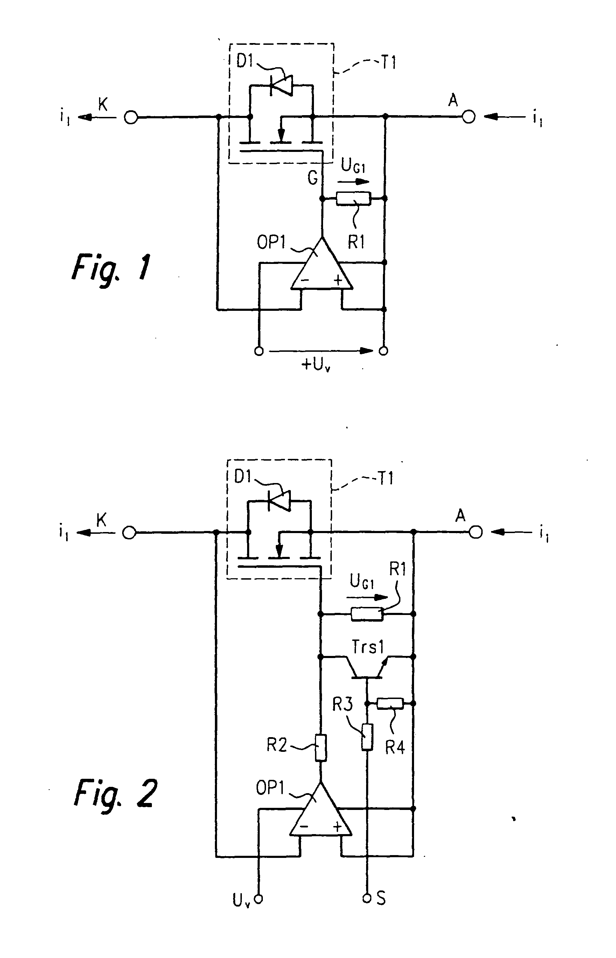

Figur 1 zeigt ein erstes Ausführungsbeispiel für den erfindungsgemäßen elektronischen Diodenschal tkreis. Wie jede bekannte Diode auch, umfasst er eine Anode A und eine Kathode K. Zwischen die Anode und die Kathode ist mindestens ein Feld-Effekt-Transistor FET T1 geschaltet, wobei die Source dieses FETs die Anode und dessen Drain die Kathode des erfindungsgemäßen Diodenschaltkreises repräsentiert. Der FET T1 weist eine interne bzw. parasitäre Diode D1 auf, welche parallel zu seiner Source-Drain-Verbindung in Durchlassrichtung geschaltet ist. Zwischen das Gate und die Source des FET ist eine Impedanz, vorzugsweise ein Widerstand R1 geschaltet, über dem die Gatespannung U_{G1} für den FET T1 abfällt. Weiterhin umfasst der elektronische Diodenschaltkreis in seinem ersten Ausführungsbeispiel einen Operationsverstärker OP1, dessen nicht-invertierender Eingang (+) an die Anode und dessen invertierender Eingang (-) an die Kathode des Diodenschaltkreises angeschlossen ist. Der Ausgang dieses ersten Operationsverstärkers OP1 ist, erforderlichenfalls über einen Widerstand R2 zur Strombegrenzung, an das Gate G des FET angeschlossen. Während seines Betriebs muss der Operationsverstärker mit einer externen Versorgungsspannung Uᵥ versorgt werden.

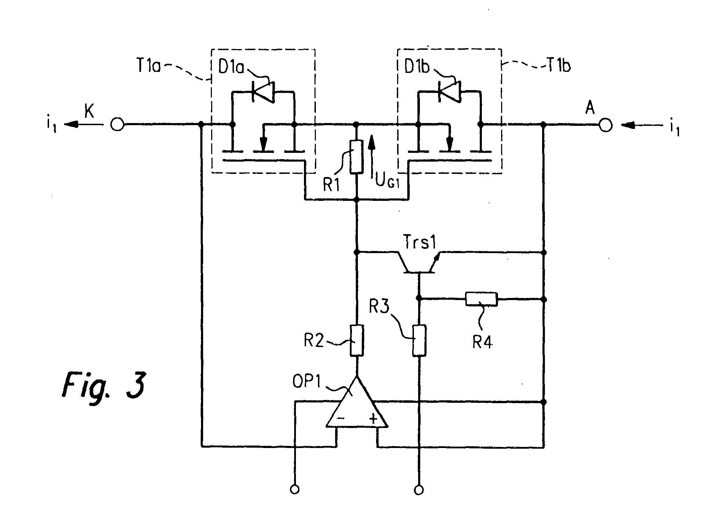

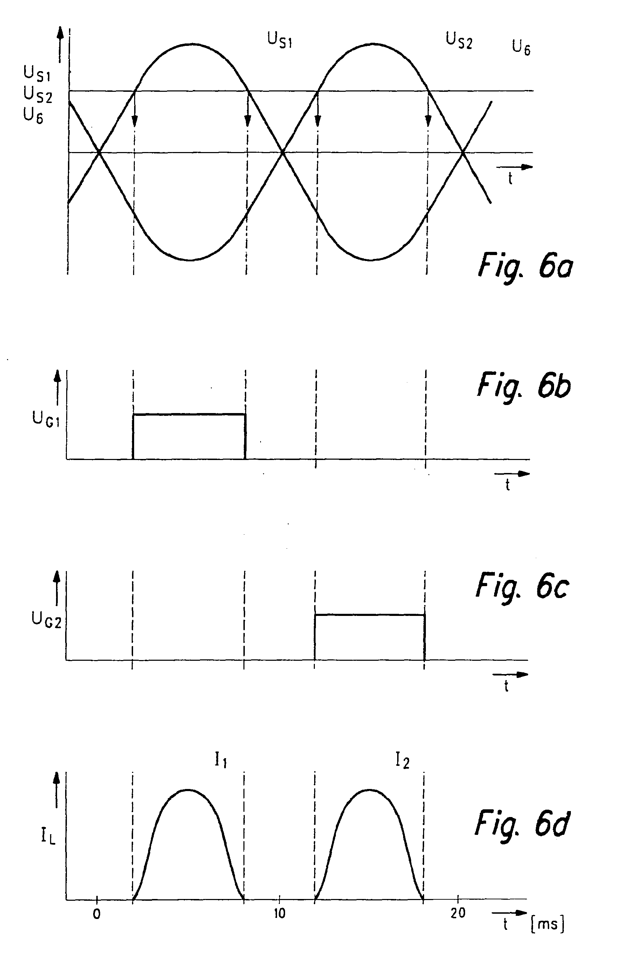

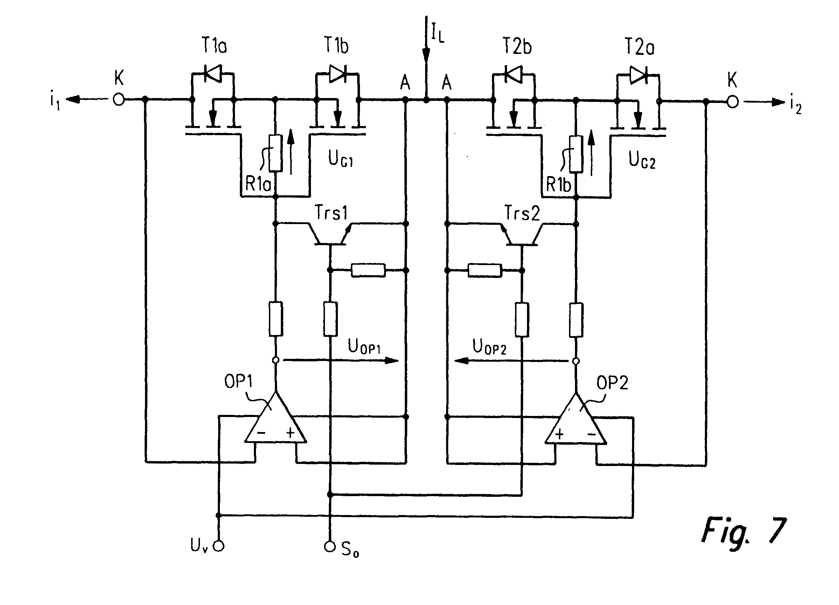

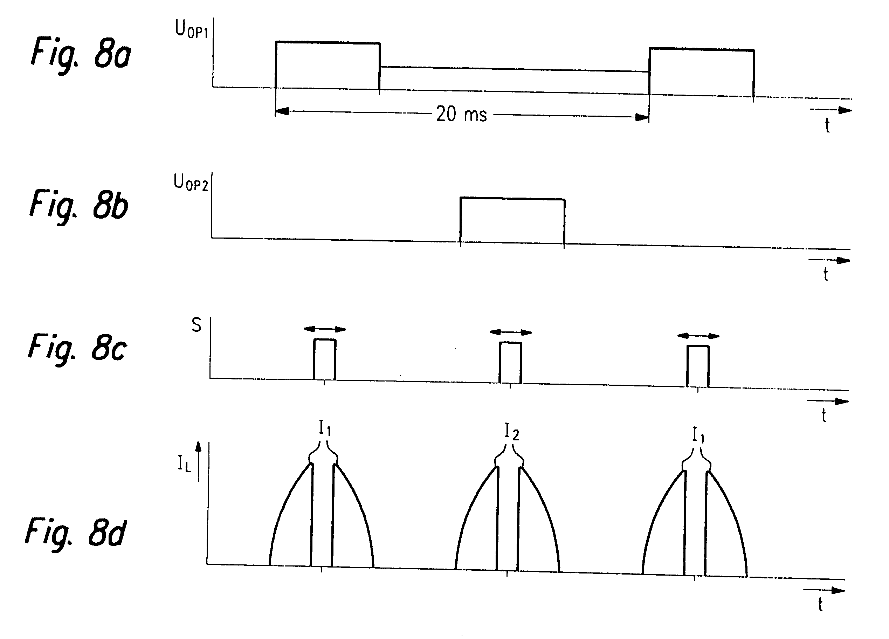

Der elektronische Diodenschaltkreis in seinem ersten Ausführungsbeispiel gemäß Figur 1 funktioniert wie folgt:
Grundsätzlich dient er dazu, einen Strom i₁ von seiner Anode A zu seiner Kathode K fließen zu lassen. Aufgrund der oben beschriebenen speziellen Anordnung der einzelnen Bauelemente kann der Diodenschaltkreis in zwei Betriebszuständen betrieben werden.
Einen ersten Zustand nimmt der Diodenschaltkreis dann ein, wenn zwischen der Anode und der Kathode und damit auch zwischen dem nicht-invertierenden und dem invertierenden Eingang des ersten Operationsverstärkers OP1 eine positive Potentialdifferenz besteht. In diesem Fall erzeugt der erste Operationsverstärker OP1 eine hoch-pegelige Ausgangsspannung, etwa in Höhe seiner Versorgungsspannung Uv. Diese führt dazu, dass die Gatespannung U_{G1} über dem Widerstand R1 ebenfalls einen positiven Wert annimmt. Damit wird die Source-Drain-Verbindung im Inneren des FET T1 für den Strom i₁ leitend und zwar auf einem sehr niederohmigen Niveau von wenigen Milliohm. Dies ist das Charakteristika des ersten Betriebszustandes des Diodenschaltkreises. Der parallel über die Diode D1 verlaufende Strompfad bleibt stromlos, da deren Flussspannung nicht erreicht wird.
Einen zweiten Betriebszustand nimmt der elektronische Diodenschaltkreis dann ein, wenn die Potentialdifferenz zwischen seiner Anode A und seiner Kathode K und damit auch zwischen dem nicht-invertierenden und dem invertierenden Eingang des Operationsverstärkers CP1 negativ ist. In diesem Fall wird die Ausgangsspannung des Operationsverstärkers und damit auch die Gatespannung U_{G1} sehr niedrig bzw. 0 Volt. Die Source-Drain-Verbindung im Inneren des FET und die Diode D1 sind dann für den Strom i₁ gesperrt. Dies ist das Charakteristikum des zweiten Betriebszustandes des Diodenschaltkreises.
Es werden nachfolgend unter Bezugnahme auf die weiteren Figuren weitere Ausführungsbeispiele und Anwendungsfälle des erfindungsgemäßen Schaltkreises beschrieben, dessen Grundtyp soeben unter Bezugnahme auf Figur 1 beschrieben wurde. Bei all diesen Ausführungsbeispielen und Anwendungen bezeichnen gleiche Bezugszeichen jeweils gleiche Bauelemente.
Figur 2 zeigt ein zweites Ausführungsbeispiel für den erfindungsgemäßen Diodenschaltkreis. Er ist eine einfache Weiterbildung des in Figur 1 gezeigten ersten Ausführungsbeispiels. Von diesem unterscheidet er sich lediglich durch ein zusätzlich eingebautes Schaltelement Trs1 in Form eines Transistors, welcher mit seiner Kollektor-Emitter-Strecke parallel zu dem Widerstand R1 geschaltet ist. Dieser Transistor Trs1 wird über ein Steuersignal S geöffnet, welches über einen Spannungsteiler R3, R4 auf die Basis des Transistors Trs1 geleitet wird. Über das Steuersignal S ist es nunmehr möglich, die Kollektor-Emitter-Strecke des Transistors Trs1 und damit auch die Gatespannung U_{G1} kurz zu schließen und damit die niederohmige Source-Drain-Verbindung zu jeder beliebigen Zeit, das heißt unabhängig von einer aktuellen Potentialdifferenz am Eingang des Operationsverstärkers OP1 und vor allem vorrangig gegenüber einer Ansteuerung durch den Operationsverstärker zu unterbrechen und damit den FET zu sperren.
Mit keinem der beiden Ausführungsbeispiele gemäß den Figuren 1 und 2 kann eine vollständige Sperrung des Strompfads von der Anode zur Kathode erzielt werden, weil in beiden Fällen immer noch ein Stromfluss über die Diode D1 möglich ist.
Um diese, für manche Anwendungsfälle unbefriedigende Situation zu ändern, wird in Figur 3 ein drittes Ausführungsbeispiel für den erfindungsgemäßen elektronischen Diodenschaltkreis beschrieben. Es baut auf dem zweiten Ausführungsbeispiel auf und unterscheidet sich von diesem lediglich darin, dass es einen zweiten FET aufweist. Dieser zweite FET T1b ist mit dem ersten, nunmehr als T1a bezeichneten FET in der Weise verschaltet, dass die beiden Gates und die beiden Sources der beiden FETs zusammengeschaltet sind und dass die Drain des ersten FETs T1a die Kathode und die Drain des zweiten FETs T1b die Anode des Diodenschaltkreises bilden.
Wenn über den Ausgang des Operationsverstärkers OP1 und den eventuell zur Strombegrenzung erforderlichen Widerstand R2 eine positive gemeinsame Gatespannung U_{G1} bereit gestellt wird, sind die Source-Drain-Verbindungen beider Transistoren durchgeschaltet und damit besteht eine sehr niederohmige Verbindung zwischen der Anode A und der Kathode K. Wird andernfalls die gemeinsame Gatespannung U_{G1} zu 0 gemacht, so sperren beide Source-Drain-Verbindungen. Es ist dann ein Stromfluss i₁ über die interne Diode Dla nicht mehr möglich, weil zum einen, wie bereits gesagt, die Source-Drain-Verbindung des zweiten FETs T1b sperrt und gleichzeitig auch die dazu parallel geschaltete interne Diode D1b des zweiten FETs für den Strom i₁ von der Anode zur Kathode in Sperrrichtung geschaltet ist. Diese Situation repräsentiert einen dritten Betriebszustand, bei dem der Diodenschaltkreis absolut stromlos ist für alle Betriebsfälle; der Diodenschaltkreis gleicht dann einem geöffneten Schalter.
Der soeben beschriebene Diodenschaltkreis findet in allen drei beschriebenen Ausführungsformen bevorzugt Anwendung in einem Ladegerät zum Aufladen eines Akkumulators. Genauer gesagt ersetzt es dort vorzugsweise die bisher verwendeten Diodenschaltkreise innerhalb einer Gleichrichtereinrichtung.

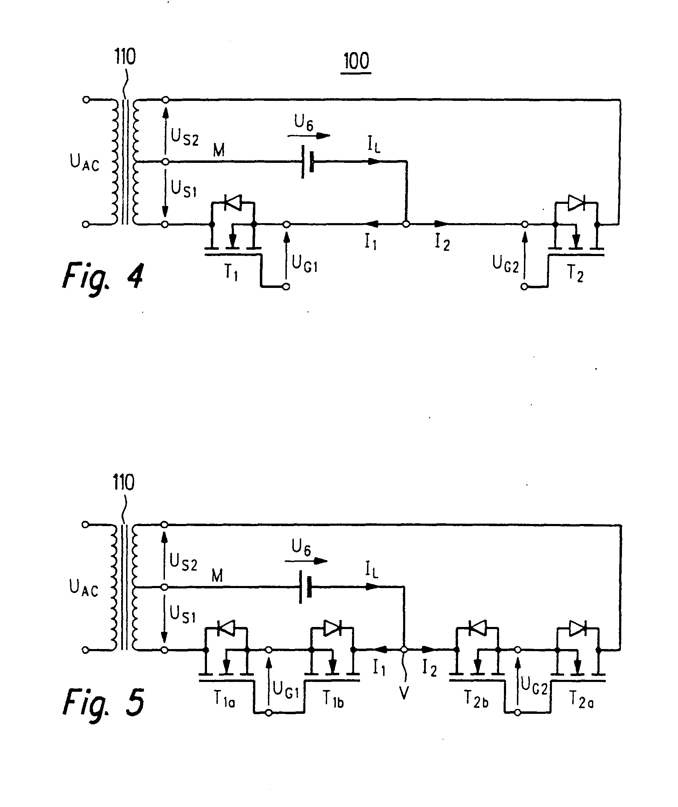

Figur 4 zeigt ein Beispiel für ein solches Ladegerät mit einem ersten Ausführungsbeispiel für die Gleichrichtereinrichtung. Es ist zu erkennen, dass das Ladegerät einen Transformator 110 aufweist, welcher primärseitig vorzugsweise mit einer 50 bzw. 60 Hertz-Netz-Spannung U_{AC} gespeist wird. Die Sekundärwicklung des Transformators 110 weist eine Mittelanzapfung M auf. Aufgrund dieser Mittelanzapfung stehen auf der Sekundärseite eine erste Sekundärspannung U_{S1} zwischen der Mittelanzapfung M und einem zweiten Endabgriff der Sekundärwicklung und eine zweite Sekundärspannung U_{S2} zwischen der Mittelanzapfung und einem ersten Endabgriff der Sekundärwicklung. Der von dem Ladegerät aufzuladende Akkumulator ist mit seinem Pluspol an die Mittelanzapfung M angeschlossen. Mit seinem Minuspol ist der Akkumulator zum einen an die Anode eines ersten Dicdenschaltkreises angeschlossen, welcher mit seiner Kathode an dem zweiten Endabgriff der Sekundärwicklung liegt. Gleichzeitig ist der Akkumulator mit seinem Minuspol an die Anode eines zweiten Diodenschaltkreises angeschlossen, der mit seiner Kathode an dem ersten Endabgriff der Sekundärspannung anliegt.
Bei dem in Figur 4 gezeigten ersten Ausführungsbeispiel der Gleichrichtereinrichtung sind die Diodenschaltkreise jeweils gemäß ihrem ersten oder ihrem zweiten Ausführungsbeispiel mit nur einem FET, wie oben unter Bezugnahme auf die Figuren 1 und 2 beschrieben, ausgebildet. Dies ist durch die in Figur 4 gezeigten FETs T1 und T2 angedeutet. Auf die Darstellung der in den Figuren 1 und 2 zusätzlich gezeigte Ansteuerschaltung dieser FETs wurde der Einfachheit halber in Figur 4 verzichtet; sie ist jedoch selbstverständlich zur Ansteuerung der FETs erforderlich.
Bei dem in Figur 5 gezeigten Ladegerät ist der Gleichrichter gemäß eines zweiten Ausführungsbeispiels ausgebildet. Dabei sind die Diodenschaltkreise jeweils gemäß ihrem dritten oben unter Bezugnahme auf Figur 3 beschriebenen Ausführungsbeispiel ausgebildet. Dies ist in Figur 7 detailliert veranschaulicht.
Unter Bezugnahme auf die Figuren 6 und 8 wird nachfolgend die Funktionsweise des in Figur 5 in Verbindung mit Figur 7 dargestellten Ladegerätes näher erläutert.
In Figur 6a sind zunächst die beiden gegenphasigen Sekundärspannungen U_{S1} und U_{S2} in ihrem zeitlichen Verlauf zu erkennen. Außerdem, ist in Figur 6a die Nennspannung U₅ des aufzuladenden Akkumulators eingezeichnet. Aus Figur 6a in Verbindung mit Figur 6b ist zu erkennen, dass die Gatespannung U_{G1} dann eingeschaltet wird, wenn die erste Sekundärspannung U₅₁ den Betrag der Batteriespannung U_{b} übersteigt. Mit dem Anlegen dieser ersten Gatespannung U_{G1} werden beide Source-Drain-Verbindungen der FETs T1a und T1b durchgeschaltet, so dass sich ein Ladestrom 11 gemäß Figur 6d durch den Akkumulator einstellt. Der erfindungsgemäße Diodenschaltkreis mit den FETs T1a und T1b wird dann in seinem ersten besonders niederohmigen Betriebszustand betrieben. Der Strompfad durch die FETs ist dann vorteilhafterweise wesentlich niederohmiger als bei Verwendung üblicher Dioden oder Thyristoren; es wird deshalb während dieser kurzen Ladephase auch eine wesentlich geringere Verlustleistung produziert.
Sobald die erste Sekundärspannung U_{S1} wieder betraglich kleiner wird als die Batteriespannung, wird die Gatespannung U_{G1} wieder abgeschaltet. Es fließt dann nach Abschalten der Gatespannung kein Ladestrom mehr. Wie in den Figuren 6a, 6c und 6d dargestellt ist, wiederholt sich das soeben für eine erste Halbwelle der Sekundärspannung beschriebene Verfahren nachfolgend während einer zweiten Halbwelle gleichermaßen in einem zweiten Zweig des Gleichrichters, in dem der zweite Diodenschaltkreis gemäß der Erfindung mit den FETs T2a und T2b enthalten ist, siehe Figur 5. Wie in insbesondere Figur 6d zu erkennen ist, wird mit dem Schaltungsaufbau gemäß Figur 5 und 7 eine Vollwellen Ladung realisiert. Dafür sind die beiden in Figur 7 gezeigten Transistoren Trs1 und Trs2 mit ihrem gemeinsamen Steuereingang S nicht erforderlich. Weil die beiden Diodenschaltkreise in Figur 7 jeweils nur antizyklisch betrieben werden, ist auch das über den. gemeinsamen Steuereingang S bereit gestellte Steuersignal jeweils nur für einen der beiden Transistoren Trs1 oder Trs2 wirksam. Es könnten deshalb auch zwei getrennte Steuersignale für die Transistoren Trs1 und Trs2 vorgesehen sein.
Der Steuereingang S kann jedoch sehr vorteilhaft zur Beeinflussung des in Figur 6d gezeigten Ladestromes eingesetzt werden. Dies wird nachfolgend unter Bezugnahme auf Figur 8 näher erläutert.
Energieversorgungsunternehmen haben grundsätzlich das Problem, dass die von ihnen bereit gestellte Netzspannung in ihren Spitzen zu sehr belastet wird. Dies liegt daran, dass die weitaus größte Mehrzahl der handelsüblichen netzbetriebenen Geräte so ausgebildet ist, dass sie die Netzspannung vorzugsweise im Bereich ihrer maximalen Amplitude belasten. Insofern ist es zumindest aus Sicht der Energieversorgungsunternehmen begrüßenswert, wenn zumindest einzelne Verbraucher, zum Beispiel Ladegeräte für Akkumulatoren, so ausgebildet sind, dass sie die Netzspannung nicht in ihrer maximalen Amplitude belasten.
Dies kann bei dem in Figur 5 in Verbindung mit Figur 7 dargestellten Ladegerät durch eine geeignete Ansteuerung der Transistoren Trs1 und Trs2 über deren gemeinsamen Steuereingang erzielt werden. Bei einer Ansteuerung dieser Transistoren über den Steuereingang S gemäß Figur 8c bewirken diese Transistoren ein Entladen der Gate-Source Kapazität aller FETs. Der Stromfluss durch die beiden FETs des jeweils einen aktiven Diodenschaltkreises wird dann sofort unterbrochen. Erst wenn die Steuerspannung an dem Steuereingang des Transistors Trs1, Trs2 des jeweils aktiven Diodenschaltkreises unter die Schaltschwelle abgesenkt wird, wird der jeweilige Diodenschaltkreis wieder eingeschaltet, sofern der jeweilige Operationsverstärker weiterhin angesteuert wird. Wie oben unter Bezugnahme auf Figur 3 bereits erläutert wurde, ermöglicht das Steuersignal S eine Unterbrechung einer eventuell auch aktuell aktiven Stromverbindung innerhalb eines erfindungsgemäßen Diodenschaltkreises unabhängig von einer aktuellen Potentialdifferenz an dessen Operationsverstärker OP1 oder CP2. So ist es bei einer geeigneten Synchronisation des Steuersignals S mit den Spitzen der Netzspannung möglich, den Ladestrom genau dann vorübergehend abzuschalten, wenn die Spitzen in der Netzspannung auf der Primärseite des Ladegerätes auftreten; dies ist in Figur 8c in Verbindung mit Figur 8d anschaulich dargestellt. Die Figuren 8a und 8b zeigen die bereits aus den Figuren 6b und 6c gezeigten Spannungsverläufe der Ausgangsspannungen der Operationsverstärker OP1 und OP2.
Aus einem Vergleich der Figuren 8a bis 8d ist ersichtlich, dass eine Ansteuerung eines der Transistoren Trs1 oder Trs2 über den Steuereingang S nur jeweils dann Sinn macht, wenn und solange die Source-Drain-Verbindungen in den zugehörigen Diodenschaltkreisen über die zugeordneten Ausgangsspannungen der Operationsverstärker und damit über ihre Gatespannungen leitend geschaltet wurden. Zu anderen Zeiten macht eine derartige Ansteuerung, die eine Abschaltung des Ladestroms zur Folge hat, keinen Sinn, weil dann in dem jeweiligen Diodenschaltkreis ohnehin kein Strom fließt. Durch eine Einstellung bzw. Steuerung der Breite der Steuerimpulse gemäß Figur 8c kann die Dauer der Unterbrechung des Ladestroms gemäß Figur 8d und damit die insgesamt während einer Halbwelle zu Ladezwecken bereit gestellte Strommenge für den Akkumulator gesteuert werden.

## Patentansprüche

1. Elektronischer Diodenschaltkreis mit einer Anode (A) und einer Kathode (K), **gekennzeichnet durch**:
mindestens einen zwischen die Anode und die Kathode geschalteten Feld-Effekt-Transistor FET (T1, T1a, T1b) mit einem Gate, einer Source und einer Drain, wobei die Kathode **durch** die Drain repräsentiert wird; und einen Operationsverstärker (OP1), dessen nicht-invertierender Eingang (+) an die Anode, dessen invertierender Eingang (-) an die Kathode und dessen Ausgang, erforderlichenfalls über einen Widerstand (R2),an das Gate des FET angeschlossen sind, zum Steuern des Betrages der Gatespannung (U_{G})nach Maßgabe **durch** die Potentialdifferenz zwischen der Anode und der Kathode.

2. Elektronischer Diodenschaltkreis nach Anspruch 1,
**dadurch gekennzeichnet, dass** zwischen das Gate und die Source des FET eine Impedanz (R1) geschaltet ist.

3. Diodenschaltkreis nach Anspruch 1 oder 2, **gekennzeichnet durch** ein gesteuertes Schaltelement (Trs1, Trs2), insbesondere einen Transistor, welches zwischen das Gate des FET (T1, T1a, T1b) und die Anode des Diodenschaltkreises geschälter ist zum Sperren des FET (T1, T1a, Tb) **durch** Bereitstellen einer elektrisch leitenden Verbindung zwischen dem Gate (G) und der Anode (A) im Ansprechen auf ein Steuersignal (S).

4. Dicdenschaltkreis nach einem der vorangegangenen Ansprüche, **gekennzeichnet durch** einen zweiten FET (T2), welcher mit seinem Gate an das Gate des ersten FET (T1), mit seiner Source an die Source des ersten FET (T1) angeschlossen ist und dessen Drain die Anode (A) repräsentiert.

5. Diodenschaltkreis nach einem der vorangegangenen Ansprüche, **dadurch gekennzeichnet, dass** der Diodenschaltkreis auf einem Chip integriert ist.

6. Gleichrichtereinrichtung zum Umwandeln einer Wechselspannung in eine Gleichspannung **gekennzeichnet durch** mindestens einen elektronischen Diodenschaltkreis gemäß einem der Ansprüche 1-5.

7. Ladegerät (110) zum Aufladen eines Akkumulators, umfassend:
einen primärseitig vorzugsweise netzgespeisten Transformator (110); und
eine Gleichrichcereinrichtung auf der Sekundärseite des Transformators mit mindestens einem Diodenschaltkreis(T1, T2) zum Bereitstellen einer gleichgerichteten Ladespannung (U_{b}) für den aufzuladenden Akkumulator;
**dadurch gekennzeichnet, dass**
der Diodenschaltkreis gemäß einem der Ansprüche 1-5 ausgebildet ist.

8. Ladegerät (110) nach Anspruch 7, **dadurch gekennzeichnet, dass** die Sekundärwicklung des Transformators (110) eine Mittelanzapfung (M) aufweist zum Bereitstellen einer ersten Sekundärspannung (US1) zwischen der Mittelanzapfung und einem zweiten Endabgriff der Sekundärwicklung und einer zweiten Sekundärspannung (US2) zwischen der Mittelanzapfung und einem ersten Endabgriff der Sekundärwicklung;
die Gleichrichtereinrichtung zwei Diodenschaltkreise aufweist, wobei die Kathode eines ersten Diodenschal tkreises an die erste Endanzapfung und die Kathode eines zweiten Diodenschaltkreises an die zweite Endanzapfung angeschlossen ist und die Anoden der beiden Diodenschaltkreise zu einem Verbindungspunkt (V) zusammengeschaltet sind; und
wobei die Ladespannung (U_{b}) für den Akkumulator zwischen der Mittelanzapfung (M) und dem Verbindungspunkt (V) der beiden Anoden bereitsteht.
